# FASCICULE DE BREVET EUROPEEN

(11) **EP 3 990 822 B1**
(45) Date de publication et mention de la délivrance du brevet: **01.11.2023**
(21) Numéro de dépôt: 20734485.4
(22) Date de dépôt: 18.06.2020
(51) Int. Cl.: F21S 41/143, F21S 41/153, F21S 43/14, F21S 43/15, H01L 25/075, H01L 33/44, H01L 33/58

(54) **DISPOSITIF LUMINEUX POUR VÉHICULE AUTOMOBILE**
KRAFTFAHRZEUGBELEUCHTUNGSVORRICHTUNG
MOTOR VEHICLE LIGHTING DEVICE

(30) Priorité: 28.06.2019 FR 1907171
(43) Date de publication de la demande: 04.05.2022
(73) Titulaire: Valeo Vision, 93012 Bobigny Cedex (FR)
(72) Inventeur: DE LAMBERTERIE, Antoine, 93012 Bobigny Cedex (FR); VAL, Alexandre, 93012 Bobigny Cedex (FR)
(74) Mandataire: Valeo Visibility
(86) Numéro de dépôt international: PCT/EP2020/067050
(87) Numéro de publication internationale: WO 2020/260143

(56) Documents cités:
- FR-A1- 3 056 014
- JP-A- 2013 187 371
- US-A1- 2015 221 619
- US-A1- 2017 309 223
- US-A1- 2018 315 893
- US-B1- 10 141 485

## Description

L'invention s'inscrit dans le domaine des dispositifs lumineux pour véhicule automobile, et plus particulièrement des dispositifs lumineux disposés dans un module de signalisation ou d'affichage d'informations disposé à l'avant et/ou à l'arrière d'un véhicule automobile.

De tels dispositifs lumineux sont utilisés dans des modules avant ou arrière des véhicules automobiles pour assurer les fonctions de signalisation, par exemple au moyen des feux clignotants, ou encore pour former un support d'informations utiles au conducteur pour la connaissance de l'état de son véhicule. Ces dispositifs lumineux peuvent ainsi présenter la forme d'un témoin de charge de la batterie du véhicule, et/ou d'un moyen de signalisation d'un danger pour les personnes extérieures du mode de roulage du véhicule, les dispositifs ayant alors pour fonction d'afficher des fonctions de signalisations et des messages de tous types, parmi lesquels des messages informatifs ou des messages d'avertissement d'un danger. Des dispositifs lumineux sont connus des documents US 2018/315893 A, JP 2013 187371 A et US 10141485 B.

Un dispositif lumineux implanté dans un projecteur ou dans un feu arrière ou avant de véhicule doit permettre de répondre à différentes exigences parmi lesquelles l'efficacité, c'est-à-dire le besoin que le message affiché soit visible même en plein jour pour pouvoir être compris par un observateur, par exemple un autre conducteur ou un piéton, et la bonne résolution, pour que les motifs affichés soient nets et offrent une bonne qualité perçue, sans que l'observateur puisse voir le ou les espaces entre des pixels du témoin lumineux.

Ces dispositifs lumineux sont classiquement réalisés en utilisant des diodes électroluminescentes (connus sous l'acronyme LED pour « Light Emitting Diode »), les dispositifs lumineux comprenant notamment un circuit électrique (PCB pour « Printed Circuit Board ») sur lequel les diodes électroluminescentes et des composants électroniques sont fixés, par exemple soudées ou brasées. Un inconvénient constaté de ce type de dispositifs lumineux est que, dans un environnement extérieur ou illuminé, des rayons lumineux externes au véhicule, par exemple provenant du soleil ou provenant directement ou indirectement de l'environnement externe au véhicule automobile, pénètrent dans le dispositif lumineux et sont réfléchis par les différents composants du dispositif lumineux tels que des pistes ou les corps des diodes électroluminescentes et composants électroniques. Il en résulte une perte de contraste des motifs lumineux affichés par les diodes électroluminescentes particulièrement lorsque la source lumineuse externe est intense.

D'autres part, il convient de protéger l'ensemble des composants du dispositif lumineux vis-à-vis des contraintes environnementales, notamment afin d'en préserver l'efficacité et d'en prolonger l'utilisation.

Afin de limiter la réflectivité des composants des dispositifs lumineux à diodes électroluminescentes, il est connu de recourir à un PCB noir mat sur lequel les différentes pistes sont recouvertes d'un revêtement. Un tel système demeure néanmoins insuffisant, les corps et les sites d'insertion et/ou de fixation des différents composants, notamment des diodes électroluminescentes ou des composants électroniques, restant partiellement visibles et aptes à réfléchir les rayons lumineux externes.

L'invention s'inscrit dans ce contexte et vise à proposer une alternative aux technologies utilisées pour former jusqu'à présent les dispositifs lumineux pour véhicule automobile, l'invention permettant une réduction de la réflectivité du dispositif lumineux mais également une protection des composants, et notamment des diodes électroluminescentes, dudit dispositif.

L'invention propose un dispositif lumineux pour véhicule automobile, tel que défini dans la revendication 1, comportant un substrat de support et une pluralité de diodes électroluminescentes disposées sur ce substrat de support, les diodes électroluminescentes comprenant chacune un corps et une zone émettrice de rayons lumineux. Le dispositif lumineux comporte également une glace de protection disposée sur la trajectoire des rayons lumineux émis par les diodes électroluminescentes. L'invention est caractérisée en ce que le dispositif lumineux comprend au moins une couche absorbante configurée pour recouvrir le substrat et au moins en partie le corps des diodes électroluminescentes et en ce que la couche absorbante présente une pluralité de cavités chacune agencée en regard de la zone émettrice de l'une des diodes électroluminescentes.

Un tel dispositif lumineux peut être implanté dans des modules disposés à l'avant et/ou à l'arrière du véhicule, et aussi bien dans des modules lumineux ayant une fonction de signalisation que dans d'autres modules ayant une fonction d'identification ou de signalisation comme par exemple des plaques d'immatriculation.

Chaque diode électroluminescente, composée tel que précisé d'un corps et d'une zone émettrice de rayons lumineux, peut consister ici en une microled ou en une miniled. On qualifie de « microled » une diode électroluminescente dont l'encombrement maximal, défini par un côté le plus long du corps de la diode électroluminescente, présente une dimension inférieure à 100 micromètres. De même on qualifie de « miniled » une diode électroluminescente dont l'encombrement maximal est une valeur comprise entre 100 et 300 micromètres. Plus particulièrement, chaque diode électroluminescente peut présenter une forme carrée ou rectangulaire définie par son corps.

Les diodes électroluminescentes sont ménagées sur le substrat de support par soudage, collage ou brasage, le substrat pouvant consister, à titre d'exemple, en un substrat multicouche céramique, un substrat silicium (Si) ou dérivés (SiC,...). Les diodes électroluminescentes sont alimentées en énergie par un générateur, la connexion électrique desdites diodes électroluminescentes étant réalisée par la soudure, la brasure, le collage ou encore par métallisation additive ou semi-additive. L'allumage des diodes électroluminescentes peut être réalisée de manière constante, ou bien peut être activé au moyen d'une commande spécifique, par exemple par le biais de la pédale de frein ou du levier des clignotants du véhicule dans un but de signalisation. L'activation d'une ou plusieurs diodes électroluminescentes est réalisée par des organes d'activation et/ou de contrôle, lesquels peuvent être portés par le substrat de support du dispositif lumineux.

Avantageusement, les diodes électroluminescentes peuvent émettre une couleur spécifique en fonction de leur composition, notamment, le dispositif lumineux comporte des diodes électroluminescentes de type RGB et/ou des diodes électroluminescentes monochromes configurées pour émettre de la couleur rouge et/ou de la couleur ambre et/ou de la couleur blanche.

Dans des dispositifs lumineux classiques, les rayons lumineux externes entrant dans le dispositif lumineux sont susceptibles d'être réfléchis par les corps des diodes électroluminescentes, par les différents composants électroniques du dispositif lumineux, tels que les organes d'activation et/ou de contrôle et par le substrat de support, par exemple un circuit imprimé, aux différentes diodes électroluminescentes. Un tel phénomène entraîne une réduction du contraste des signaux lumineux émis par les dispositifs lumineux.

Afin de prévenir un tel phénomène, le dispositif lumineux selon la présente invention comprend la couche absorbante des rayons lumineux externes au véhicule automobile, réalisée d'un seul tenant et qui s'étend sur le substrat de support porteur des diodes électroluminescentes de manière à couvrir tout élément visible susceptible de réfléchir des rayons lumineux externes, par exemple émis par le soleil, la couche absorbante couvrant notamment au moins en partie le corps des diodes électroluminescentes, les organes d'activation et/ou de contrôle du dispositif lumineux. Également, la connexion électrique des diodes électroluminescentes étant traditionnellement réalisée par câblage filaire, la couche absorbante est configurée pour recouvrir des électrodes alimentant les diodes électroluminescentes, que celles-ci soient ménagées au niveau d'une base de chaque diode électroluminescente ou que les diodes électroluminescentes présentent des électrodes verticales. Alternativement, une connexion électrique par l'intermédiaire d'un moyen additif ou semi-additif (mSAP ou SAP) pourra être envisagée.

Afin de minimiser la réflectivité du dispositif lumineux, la couche absorbante est configurée pour optimiser l'absorption des rayons lumineux externes. A cette fin, la couche absorbante est préférentiellement opaque et/ou noire. La couche absorbante peut particulièrement être réalisée par surmoulage, en utilisant un matériau tel qu'un silicone, une résine époxyde, polyuréthane ou acrylique, la couche absorbante étant, par exemple, surmoulée sur le substrat porteur des diodes électroluminescentes et des organes d'activation et/ou de contrôle. La couche absorbante présente au moins une épaisseur de 50 micromètres. Avantageusement, la surface de la couche absorbante pourra être soumise à au moins un traitement destiné à préparer ladite surface pour faciliter l'adhésion de toute couche additionnelle susceptible d'être superposée sur la couche absorbante.

Afin de ne pas entraver l'émission de rayons lumineux par les diodes électroluminescentes et donc afin de ne pas réduire les performances du dispositif lumineux, la couche absorbante comprend les cavités, lesquelles sont ménagées en regard d'au moins l'une des diodes électroluminescentes. Chaque cavité est délimitée par une pluralité de pans longeant des bords de la zone émettrice de la diode électroluminescente, de sorte que la couche absorbante s'étend sur le corps de la diode électroluminescente mais dégage la zone émettrice de rayon lumineux de celle-ci. Particulièrement la zone émettrice et le fond de la cavité peuvent présenter des formes sensiblement identiques, par exemple carrée ou rectangulaire, la cavité étant centrée sur la zone émettrice.

Avantageusement, une telle couche absorbante forme une barrière mécanique prévenant la diffusion de l'humidité et de tout autre élément liquide ou gazeux susceptible d'altérer les pistes conductrices ou des joints d'interconnexion des composants portés par le substrat de support. Également, la couche absorbante améliore la résistance mécanique de ces mêmes composants, leur fournissant une meilleure tenue dans le temps.

Selon une caractéristique de l'invention, au moins l'une des cavités est délimitée par une pluralité de pans inclinés, lesdits pans inclinés présentant un angle α compris entre 0 et 45° par rapport à un plan d'extension comprenant la zone émettrice de la diode électroluminescente correspondante.

Une telle inclinaison contribue à optimiser le recouvrement des parties réfléchissantes, notamment des corps des diodes électroluminescentes ou de leurs électrodes, sans dégrader la performance de la zone émettrice de la diode électroluminescente correspondante. Une telle configuration de chaque cavité peut, notamment, être obtenue par la conception spécifique d'un contre-moule utilisé lors de la réalisation de la couche absorbante par surmoulage.

De la sorte, la couche absorbante comprend une surface inférieure, qui est en contact des différents composants du dispositifs lumineux et notamment du substrat de support et des corps des différentes diodes électroluminescentes, et depuis laquelle s'étendent les différents plans inclinés. La couche absorbante assure ainsi un recouvrement étanche optimisé des composants placés sur le substrat de support, limitant leur réflexion des rayons lumineux externes et réduisant leur dégradation résultant des conditions environnementales standards impliquées dans l'automobile.

Selon une caractéristique de la présente invention, une surface supérieure de la couche absorbante, à l'opposé de substrat, comprend un grainage.

Plus précisément, la surface supérieure est la surface opposée qui est tournée vers la glace de protection du dispositif lumineux. Par grainage on entend que la surface supérieure de la couche absorbante présente des aspérités, par exemple un bosselage ou une rugosité, destinée à donner à la surface supérieure un aspect mat limitant la réflexion directe des rayons lumineux externes en direction d'un observateur externe.

Selon une caractéristique de l'invention, le dispositif lumineux comprend au moins une couche complémentaire qui s'étend au moins en partie dans au moins l'une des cavités de la couche absorbante.

Selon une caractéristique de l'invention, la couche complémentaire peut être transparente. En d'autres termes, la couche complémentaire laisse passer les rayons lumineux émis par la diode électroluminescente. Notamment, la couche complémentaire peut être transparente incolore ou transparente teintée.

Selon une caractéristique de l'invention, la couche complémentaire consiste en une couche complémentaire locale disposée dans l'une des cavités et réalisée dans un matériau caractérisé par un premier indice de réfraction, sensiblement égal à un deuxième indice de réfraction de la zone émettrice de la diode électroluminescente disposée dans la cavité correspondante.

La couche complémentaire du dispositif lumineux peut être obtenue par simple dépôt de matière ou selon une opération de surmoulage. Notamment, la couche complémentaire peut notamment consister en une couche complémentaire locale dont le dépôt est ciblé pour recouvrir spécifiquement une surface émettrice à l'intérieur d'une cavité. La couche complémentaire locale est ainsi configurée pour remplir au moins partiellement au moins l'une des cavités de la couche absorbante du dispositif lumineux afin d'assurer le recouvrement de la zone émettrice de la diode électroluminescente s'étendant en regard de la cavité correspondante. Selon la quantité de matériau déposée, la couche complémentaire locale peut ainsi former un dépôt concave ou convexe au niveau d'au moins l'une des cavités, la couche complémentaire recouvrant ainsi la zone émettrice sur laquelle est centrée ladite cavité de manière à assurer une protection supplémentaire.

Notamment, le dispositif lumineux peut comprendre une pluralité de couches complémentaires, par exemple une pluralité de couches complémentaires locales.

L'indice de réfraction du matériau formant la couche complémentaire est proche de l'indice de réfraction de la diode électroluminescente, notamment d'une couche de la diode électroluminescente la plus éloignée de la base de ladite diode qui est brasée sur le substrat de support, afin d'optimiser l'émission des rayons lumineux en facilitant le passage entre la surface émettrice de la diode électroluminescente et les matériaux formant les différentes couches du dispositif lumineux.

Le matériau utilisé pour la réalisation de la couche complémentaire peut être du silicone, de l'acrylique, ou une résine en polyuréthane par exemple. Avantageusement, le matériau utilisé pour la couche complémentaire est le même que celui utilisé pour la couche absorbante, à la teinte près. En d'autres termes, si la couche absorbante est réalisée par l'utilisation d'une résine polyuréthane opaque absorbante, la couche complémentaire est réalisée par l'utilisation d'une résine polyuréthane transparente. On comprend que cette configuration permet une compatibilité des matériaux lors des étapes d'obtention par injection localisée ou par surmoulage, de manière à faciliter l'adhérence de l'un sur l'autre et la tenue mécanique du produit fini.

Selon une caractéristique du premier mode de réalisation, la couche complémentaire locale disposée dans l'une des cavités peut être réalisée dans un matériau luminophore ou dans un matériau teinté dans une couleur sensiblement identique à une couleur de la lumière émise par la source de la diode électroluminescente ménagée dans la cavité correspondante.

Autrement dit, au moins l'une des zones émettrices de l'une des diodes électroluminescentes peut être recouverte par une couche complémentaire locale réalisée dans un matériau luminophore. Le luminophore est un élément disposé sur la diode électroluminescente afin de modifier la longueur d'onde d'une partie, ou de tous, les photons émis par celle-ci, ce qui permet d'utiliser des diodes électroluminescentes émettant à la base une lumière bleue. Dans les dispositifs lumineux destinés à des véhicules automobiles, il est notamment connu d'utiliser des luminophores tels que des phosphores jaune, ambre ou rouge pour former respectivement du blanc, de l'orange ou du rouge, qui sont des couleurs correspondantes aux normes des avertisseurs lumineux des véhicules.

Particulièrement, le dispositif lumineux peut être configuré de manière à comprendre une pluralité de luminophores différents, déposés dans des cavités distinctes.

Alternativement, au moins l'une des zones émettrices de l'une des diodes électroluminescentes peut être recouverte par une couche complémentaire locale réalisée dans un matériau teinté, c'est-à-dire dans un matériau transparent coloré. Une telle alternative est applicable dès lors que la diode électroluminescente correspondante est monochrome, c'est-à-dire qu'on observe une émission de rayons lumineux caractérisés par une unique longueur d'onde. Ainsi, par exemple, une cavité centrée sur une zone émettrice d'une diode électroluminescente émettant des rayons lumineux rouges peut être, au moins en partie, remplie d'une couche complémentaire teintée en rouge. Il résulte d'une telle alternative que l'effet de tout rayon lumineux externe résiduel qui pénètre dans la diode électroluminescente au niveau de sa zone émettrice est fortement réduit, la couche complémentaire formant ainsi un filtre réduisant les rayons lumineux externes sans pour autant affecter les rayons lumineux émis par la diode électroluminescente elle-même.

Il convient de noter que les caractéristiques qui viennent d'être décrites peuvent être combinées de manière non limitative. Ainsi, le dispositif lumineux peut être configuré de sorte qu'une première couche complémentaire, par exemple une première couche complémentaire locale, s'étendant dans au moins une première cavité est réalisée dans un matériau luminophore tandis qu'au moins une deuxième couche complémentaire s'étendant dans une deuxième cavité est réalisée dans un matériau transparent ou teinté dans une couleur sensiblement identique à une couleur de la lumière émise par la source de la diode électroluminescente ménagée dans ladite deuxième cavité.

Selon une caractéristique de l'invention, la couche complémentaire s'étend au moins en partie sur la couche absorbante, la couche complémentaire pouvant présenter une épaisseur comprise entre 1 et 40 µm par rapport à une face inférieure de la couche complémentaire qui est en contact avec la couche absorbante.

Notamment, lorsque la couche complémentaire consiste en une couche complémentaire locale, celle-ci s'étend sur la couche absorbante au niveau des pans, par exemple des pans inclinés, de la cavité dans laquelle ladite couche s'étend.

Alternativement, la couche complémentaire peut consister en une couche complémentaire de recouvrement qui peut être réalisée d'un seul tenant, la couche complémentaire de recouvrement étant transparente, notamment transparente incolore. La couche complémentaire de recouvrement peut s'étendre au moins partiellement dans au moins l'une des cavités et la couche complémentaire de recouvrement s'étendant au moins en partie sur la couche absorbante, par exemple au niveau d'une portion plane de ladite couche absorbante séparant deux cavités adjacentes. L'épaisseur de la couche complémentaire de recouvrement est notamment mesurée au niveau d'une portion de la couche complémentaire de recouvrement s'étendant sur une portion plane de la couche absorbante dépourvue de cavité. Le dépôt de la couche complémentaire de recouvrement peut alors, par exemple, être réalisé par surmoulage.

Tel que précisé précédemment, des combinaisons sont possibles de sorte que le dispositif lumineux peut comporter au moins la première cavité de la couche absorbante dans laquelle s'étend la première couche complémentaire locale réalisée dans un matériau luminophore, transparent ou teinté et de sorte que le dispositif lumineux peut comporter en outre une couche complémentaire de recouvrement qui s'étend sur la couche absorbante, le cas échéant dans une ou plusieurs autres cavités, et qui s'étend sur la première couche complémentaire locale.

Selon une caractéristique de l'invention, une face supérieure de la couche complémentaire, opposée à une face inférieure de la couche complémentaire qui est en contact avec la zone émettrice d'au moins l'une des diodes électroluminescente et/ou qui est en contact avec la surface supérieure de la couche absorbante, comprend des éléments diffusants.

Notamment, les éléments diffusants peuvent s'étendre de manière ponctuelle ou sur l'intégralité de la surface supérieure de la couche complémentaire, de tels éléments diffusants étant disposés en regard d'au moins la zone émettrice d'au moins l'une des diodes électroluminescentes.

Ces éléments diffusants peuvent notamment être un grainage de la face supérieure tel que précédemment exposé pour la surface supérieure de la couche absorbante, consistant en des aspérités ou en une rugosité de la face supérieure. Également, les éléments diffusants peuvent être des structures géométriques fines, telles que des prismes ou des bossages. Ces éléments diffusants permettent d'une part d'optimiser la diffusion en sortie du dispositif de la lumière émise par les diodes et d'autre part de limiter la perte de contraste lorsqu'une source à haute luminance comme le soleil se réfléchit sur la face supérieure de la couche complémentaire.

Selon la géométrie des éléments diffusants, ceux-ci peuvent être obtenus par un traitement de surface par moulage ou par voie gazeuse par exemple, les substances gazeuses injectées réagissant de manière sélective avec la couche absorbante de manière à induire une rugosité de la surface supérieure de ladite couche. Ces éléments diffusants peuvent également être obtenus par dépôt de matière selon des procédés usuels tels que le dépôt par centrifugation (en anglais « spin coating »), par laminage de film mince par sérigraphie ou par jet de microparticules par exemple.

Avantageusement, le dispositif lumineux peut être configuré afin que la surface supérieure de la couche absorbante présente le grainage et que la face supérieure de la couche complémentaire présente des éléments diffusants.

Selon une configuration alternative à ces différents modes de réalisation, au moins une couche intermédiaire fine d'un matériau minéral transparent, tel que du SiO₂, peut être déposée entre la couche complémentaire, qu'elle soit couche complémentaire disposée de façon ciblée dans les cavités ou couche complémentaire de recouvrement déposée sur une grande étendue du substrat de support, et la couche absorbante. Une telle couche intermédiaire confère au dispositif lumineux une résistance additionnelle aux produits chimiques tels que l'eau ou les contaminants ioniques, elle s'étend aussi bien sur la surface supérieure de la couche absorbante que sur les zones émettrices des différentes diodes électroluminescentes. Lorsque la couche complémentaire de recouvrement ou locale est présente, celle-ci contribue alors à protéger, au moins en partie, la couche minérale intermédiaire.

L'invention concerne également un feu arrière ou avant de véhicule automobile comportant au moins un dispositif lumineux tel que précédemment exposé.

L'invention concerne également un procédé de réalisation d'un dispositif lumineux tel que précédemment décrit, comprenant au moins une étape de surmoulage d'une couche absorbante sur un substrat de support porteur d'une pluralité de diodes électroluminescentes au cours de laquelle on injecte un premier matériau, absorbant et/ou opaque, entre ledit substrat et un contre-moule comprenant une pluralité de reliefs configurés pour recouvrir respectivement une zone émettrice d'une diode électroluminescente.

Également, le procédé de réalisation du dispositif lumineux comprend une deuxième étape de retrait du contre-moule.

Ce procédé peut comprendre une étape additionnelle, cette troisième étape consistant en une dépose d'un matériau distinct, par exemple un matériau transparent, teinté, ou un luminophore, en recouvrement de la couche absorbante. Cette troisième étape peut consister en une dépose ciblée de ce matériau, une fois le contre-moule retiré, pour former des couches complémentaires locales dans une ou plusieurs cavités. Elle peut également être réalisée avant le retrait du contre moule, ce dernier étant décalé après la première étape pour être éloigné de la couche absorbante qui vient d'être injectée, d'une distance correspondant à l'épaisseur de la couche complémentaire de recouvrement transparente que l'on souhaite déposer sur toute la surface de la couche absorbante.

Alternativement le procédé de réalisation peut comprendre au moins une étape intermédiaire, effectuée après la deuxième étape de retrait du moule et avant la troisième étape de dépose du matériau transparent, teinté, ou du luminophore, de traitement d'une surface supérieure de la couche absorbante et/ou de dépôt d'une couche minérale intermédiaire transparente.

Avantageusement le procédé de réalisation peut comprendre au moins une étape terminale, effectuée après l'étape de dépose du matériau transparent, teinté ou du luminophore en une couche complémentaire de recouvrement ou en une couche complémentaire locale, de traitement d'une face supérieure de la couche complémentaire de recouvrement ou locale et/ou de dépose d'un traitement antireflet.

D'autres caractéristiques, détails et avantages de l'invention ressortiront plus clairement à la lecture de la description détaillée donnée ci-après, et de plusieurs exemples de réalisation donnés à titre indicatif et non limitatif en référence aux dessins schématiques annexés, sur lesquels :
[Fig.1] illustre un véhicule automobile vu de l'arrière de manière à rendre visible un phare, ici un feu arrière, dans lequel est apte à être implanté un dispositif lumineux conforme à un aspect de l'invention ;
[Fig.2] est une illustration schématique partielle d'un dispositif lumineux selon l'invention ;
[Fig.3] est une illustration schématique partielle d'un substrat de support des diodes électroluminescentes du dispositif lumineux de la figure 2 ;
[Fig.4] est une représentation schématique d'un dispositif lumineux selon un premier mode de réalisation, vue en coupe transversale, rendant visible le substrat recouvert d'une couche absorbante, illustrant l'agencement relatif de la couche absorbante et de deux diodes électroluminescentes monochromes ;
[Fig.5] est une représentation schématique d'une coupe transversale centrée sur deux diodes électroluminescentes RGB d'un dispositif lumineux tel qu'illustré dans la figure 4 lorsque celui-ci est réalisé selon une alternative de l'invention ;
[Fig.6] est une représentation schématique d'une coupe transversale centrée sur une pluralité de diodes électroluminescentes monochromes d'un dispositif lumineux tel qu'illustré dans la figure 4, lorsque celui-ci est réalisé selon une alternative de l'invention ;
[Fig.7] est une représentation schématique d'une coupe transversale centrée sur trois diodes électroluminescentes monochromes d'un dispositif lumineux réalisé selon un deuxième mode de réalisation ;
[Fig.8] est une représentation schématique d'une coupe transversale centrée sur deux diodes électroluminescentes RGB du dispositif lumineux réalisé selon le deuxième mode de réalisation ;
[Fig.9] est une représentation schématique d'une coupe transversale centrée sur deux diodes électroluminescentes monochromes d'un dispositif lumineux réalisé selon un troisième mode de réalisation ;
[Fig.10] est une représentation schématique d'une coupe transversale centrée sur deux diodes électroluminescentes monochromes d'un dispositif lumineux réalisé selon un quatrième mode de réalisation ;
[Fig.11] est une représentation schématique d'une première étape du procédé de réalisation du dispositif lumineux.

Il faut tout d'abord noter que les figures exposent l'invention de manière détaillée pour sa mise en oeuvre, mais que lesdites figures peuvent bien entendu servir à mieux définir l'invention, le cas échéant.

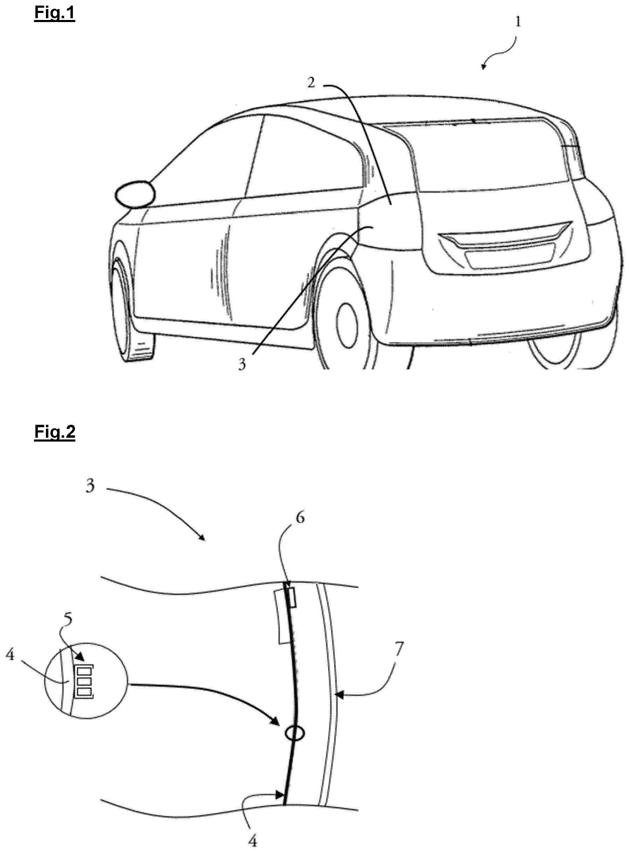

La figure 1 illustre un véhicule 1 automobile et permet de visualiser des feux 2 arrière de véhicule 1, l'un de ces feux 2 arrière étant équipé d'un dispositif lumineux 3 à diodes électroluminescentes. Également, on pourra prévoir d'équiper un tel dispositif lumineux 3 au niveau de différents feux 2 arrière et/ou avant du véhicule 1.

Dans l'exemple illustré, le dispositif lumineux 3 peut être configuré pour avertir d'une situation de danger les conducteurs qui suivent le véhicule 1, ou bien les piétons qui peuvent être amenés à traverser une route derrière ou devant le véhicule 1 par exemple. Selon l'invention, les diodes électroluminescentes mise en oeuvre pour former la source lumineuse du dispositif lumineux 3 permettent d'afficher un signal ou un message avec une résolution adaptée au déchiffrage de l'information par un observateur plus ou moins distant du véhicule 1 automobile, en plein jour le cas échéant. Également, le dispositif lumineux 3 peut être utilisé pour des fonctions de signalisation, notamment dans des feux 2 clignotants avant ou arrière.

La figure 2 illustre, schématiquement, une partie du dispositif lumineux 3 selon l'invention. Le dispositif lumineux 3 comporte un substrat 4 de support, par exemple un substrat multicouche céramique qui forme un circuit imprimé, qui est porteur d'une pluralité de diodes électroluminescentes 5 et de composants électroniques, tels que des organes d'activation et/ou de contrôle 6 de l'émission lumineuse réalisée par lesdites diodes électroluminescentes 5. Le dispositif lumineux 3 peut également, tel qu'illustré, comprendre une glace de protection 7 disposée sur la trajectoire des rayons lumineux émis par les diodes du dispositif lumineux 3.

La glace de protection 7 et le substrat 4 peuvent, tel qu'illustrés, présenter une structure galbée afin de s'adapter à la carrosserie du véhicule 1. A cet effet, le substrat 4 de support des diodes électroluminescentes 5 peut avantageusement être souple.

Les organes d'activation et/ou de contrôle 6 sont des éléments de connexion électroniques qui permettent d'amener le courant vers chacune des diodes électroluminescentes 5 et qui permettent, le cas échéant, de les piloter séparément les unes des autres en fonction de l'information à afficher par le dispositif lumineux. Chaque organe d'activation et/ou de contrôle 6 peut être configuré pour contrôler une ou plusieurs diodes électroluminescentes 5.

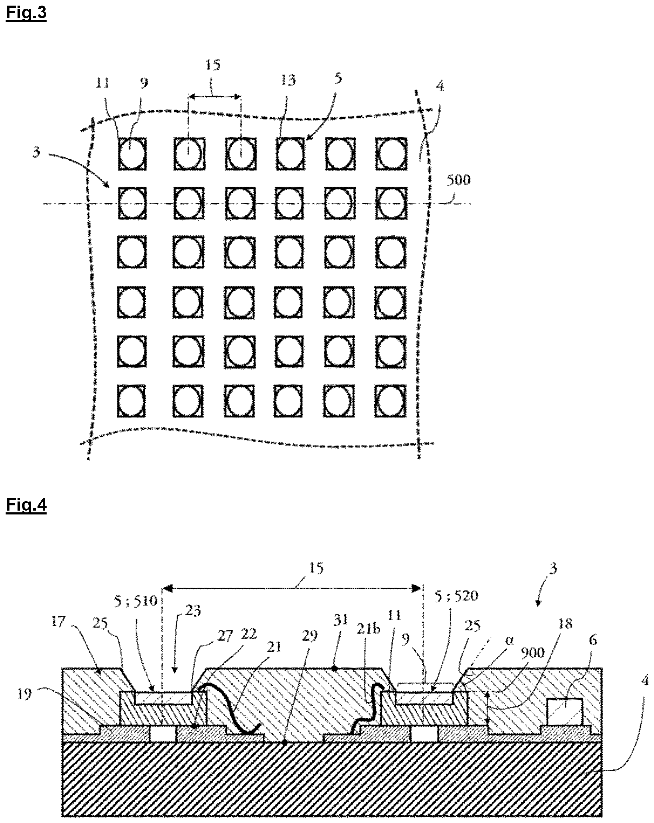

La figure 3 illustre schématiquement le substrat 4 de support porteur des différentes diodes électroluminescentes 5 et un exemple d'agencement relatif desdites diodes électroluminescentes 5. Il est à noter que cet agencement est décrit à titre explicatif et ne limite en rien la présente invention.

Les diodes électroluminescentes 5 peuvent consister en une pluralité de microleds et/ou de minileds régulièrement agencées sur le substrat 4 du dispositif lumineux 3. Les diodes électroluminescentes 5 comprennent une zone émettrice 9 de rayons lumineux dont la taille, définie par un plus grand côté 13 de la diode électroluminescente, est comprise entre 10 et 150 micromètres. La diode électroluminescente comprend également un corps 11 qui entoure la zone émettrice 9 et présente, dans l'exemple illustré, une structure parallélépipédique dont un encombrement maximum, défini par un plus grand côté 13 de la diode électroluminescente, est compris entre 20 et 200 micromètres, le corps 11 formant ainsi une bordure d'une largeur comprise entre 10 et 50 micromètres autour de la zone émettrice 9.

Les diodes électroluminescentes 5 peuvent émettre une couleur spécifique en fonction de leur composition. Notamment, le dispositif lumineux 3 peut comporter un ensemble de diodes électroluminescentes 5 de type RGB et/ou de diodes électroluminescentes 5 monochromes, c'est à dire configurées pour émettre une seule couleur, notamment pour émettre de la couleur rouge ou de la couleur ambre ou de la couleur blanche. Des diodes électroluminescentes 5 émettant une couleur différente l'une par rapport à l'autre peuvent ainsi être voisines, par exemple pour mettre en oeuvre un dispositif de signalisation permettant d'alterner deux couleurs pour avertir de manière visuelle les autres usagers. Une telle alternance peut par exemple être réalisée selon que les diodes électroluminescentes 5 sont alimentées ou non en fonction des commandes effectuées par le conducteur du véhicule, une commande affichant la couleur correspondante à l'action effectuée, par exemple l'allumage des diodes électroluminescentes 5 de couleur rouge lorsque le conducteur actionne la pédale de frein.

Les diodes électroluminescentes 5 sont agencées de manière à former des pixels espacés les uns des autres. Les diodes électroluminescentes 5 sont rapportées sur le substrat 4 de support selon un agencement régulier, chaque diode électroluminescente 5 étant séparée de la diode électroluminescente 5 adjacente par un pas 15 sensiblement égal, mesuré de centre à centre de deux diodes électroluminescentes 5 adjacentes. Selon la couleur émise par les diodes électroluminescentes 5, ce pas 15 peut être amené à varier. Notamment deux diodes électroluminescentes 5 monochromes voisines peuvent être séparées l'une de l'autre d'un pas 15 d'environ 300 micromètres tandis que deux diodes électroluminescentes 5 RGB voisines peuvent être séparées d'un pas 15 d'environ 100 micromètres. Il est donc à noter que les représentations des figures 2 et 3 sont schématiques, les diodes électroluminescentes 5 étant illustrées avec un espace entre elles exagéré pour les distinguer.

Les figures 4 à 10 détaillées ci-après représentent différents modes de réalisation du dispositif lumineux, en illustrant plus particulièrement le substrat 4 du dispositif lumineux 3 selon une coupe transversale réalisée le long d'un plan transversal 500 tel qu'illustré dans la figure 3.

Les figures 4 à 6 illustrent un premier mode de réalisation et des alternatives à ce premier mode mettant en oeuvre des diodes électroluminescentes 5 émettant des couleurs différentes.

La figure 4 représente partiellement le substrat 4 du dispositif lumineux 3, porteur d'une pluralité de diodes électroluminescentes 5, ici au nombre de deux. Les deux diodes électroluminescentes 5 sont monochromes et, dans l'exemple illustré, émettent des rayons lumineux d'une même couleur, par exemple le rouge. Également, dans l'exemple illustré, les diodes électroluminescentes 5 monochromes s'étendent sur une hauteur 18 comprise entre 50 et 150 micromètres et elles sont séparées l'une de l'autre par un pas 15 d'environ 300 micromètres.

Les diodes électroluminescentes 5 sont ménagées au niveau de segments conducteurs 19 du substrat 4 de support. Afin d'alimenter les diodes électroluminescentes 5, celles-ci peuvent être connectées aux segments conducteurs 19 par deux électrodes 21. Ces électrodes 21 peuvent être verticales, telles que représentées sur une première diode électroluminescente 510 dans la figure 4, ou elles peuvent être ménagées au niveau d'une base 22 de la diode électroluminescente 5.

Alternativement, la diode électroluminescente 5 peut comprendre une connexion électrique 21b réalisée selon un procédé additif ou semi-additif (« SAP » ou « mSAP ») d'un matériau électriquement conducteur, tel que du cuivre ou de l'or par exemple, comme représenté pour une deuxième diode électroluminescente 520, voisine de la première diode électroluminescente 510.

Les diodes électroluminescentes 5 comprennent chacune une zone émettrice 9 et un corps 11. Le corps 11 comporte une base 22 qui est, au moins en partie, en contact avec le substrat 4 et/ou les segments conducteurs 19 compris dans le substrat 4. La zone émettrice 9 est tournée vers une direction opposée au substrat 4.

Selon l'invention, le dispositif lumineux 3 comprend au moins une couche absorbante 17 disposée en revêtement des diodes électroluminescentes 5 et des organes d'activation et/ou de contrôle 6. Elle permet d'une part de protéger ces différents composants des contraintes environnementales et d'autre part d'empêcher que des rayons lumineux provenant de l'environnement extérieur, par exemple émis par le soleil, qui pénètrent dans le dispositif lumineux 3 puissent être réfléchis par les différents composants du dispositif lumineux 3 tels que les segments conducteurs 19, formant des pistes, ou les corps 11 des diodes électroluminescentes 5. A cette fin, la couche absorbante est préférentiellement opaque et/ou noire. Cette couche absorbante permet ainsi de conserver un bon contraste des motifs lumineux affichés par le dispositif lumineux via l'activation des diodes électroluminescentes 5.

Pour ne pas entraver l'émission des rayons lumineux par les diodes électroluminescentes 5, la couche absorbante 17 comprend une pluralité de cavités 23, chaque cavité 23 étant ménagée en regard de l'une des diodes électroluminescentes 5 du dispositif lumineux 3. Plus spécifiquement, les cavités 23 sont dimensionnées pour découvrir la zone émettrice 9 de chaque diode électroluminescente 5 tout en recouvrant le corps 11 entourant chacune de ces zones émettrices, chaque cavité 23 étant centrée sur une zone émettrice 9 de l'une des diodes électroluminescentes 5.

Chaque cavité 23 est délimitée par des pans inclinés 25 orientés pour que l'ouverture s'évase en s'éloignant de la diode et dont l'extrémité proximale, c'est à dire l'extrémité proche de la diode correspondante, longent les bords 27 de la zone émettrice 9 de la diode électroluminescente, de sorte que la couche absorbante 17 s'étend sur le corps 11 de la diode électroluminescente 5 sans entraver le passage des rayon lumineux émis par la zone émettrice 9. Les pans inclinés 25 présentant un angle α compris entre 0 et 45° par rapport à un plan d'extension 900 comprenant la zone émettrice 9 de la diode électroluminescente 5 sur laquelle s'ouvre la cavité 23. Le procédé d'obtention de telles cavités 23 sera davantage détaillé ci-après.

La couche absorbante 17 est ainsi répandue sur l'ensemble du substrat 4 et des composants qu'il porte, à l'exception des zones émettrices 9 des diodes électroluminescentes 5. Une surface inférieure 29 de la couche absorbante 17 est ainsi en contact avec le substrat 4, les différents segments conducteurs 19, les corps 11 des diodes électroluminescentes 5 et les organes d'activation et/ou de contrôle 6 de manière à assurer un recouvrement étanche de ces composants.

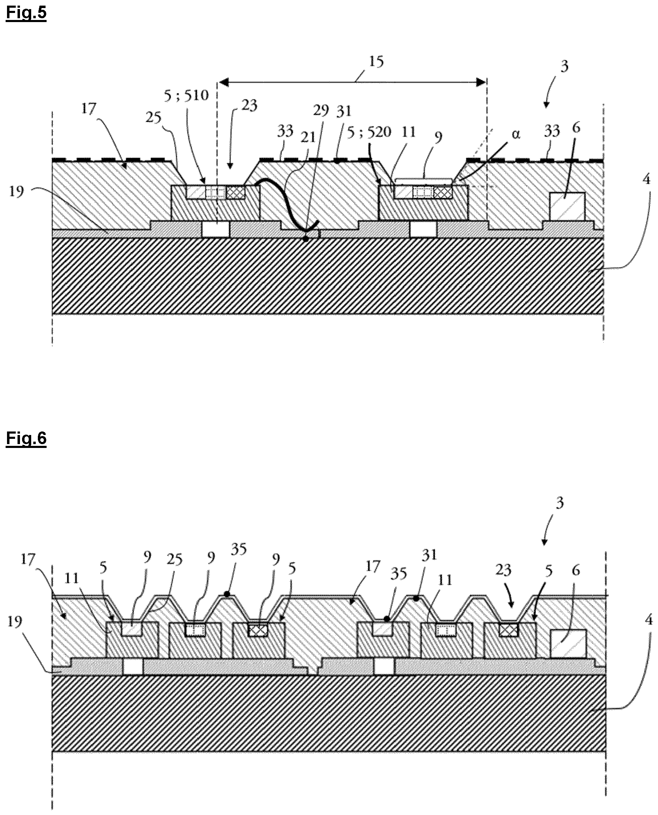

Une surface supérieure 31 de la couche absorbante 17, opposée à la surface inférieure 29, est tournée vers une direction opposée au substrat 4, par exemple vers la glace de protection 7 d'un feu. La surface supérieure 31 peut être plane, telle qu'illustrée dans la figure 4, ou présenter un grainage 33, telle que schématiquement représentée dans la figure 5. Ce grainage 33 confère alors à la surface supérieure 31 un aspect mat qui limite la réflexion des rayons lumineux externes par la couche absorbante 17.

Le grainage 33 peut, par exemple, être obtenu par traitement de surface par voie gazeuse ou encore par moulage, lors de la réalisation de la couche absorbante 17.

La figure 5 représente une alternative au premier mode de réalisation, qui diffère ce qui précède en ce que la couche absorbante 17 est appliquée en recouvrement d'un substrat 4 qui est cette fois porteur de deux diodes électroluminescentes 5 RGB à la place des diodes monochromes. Les caractéristiques du dispositif lumineux 3 sont sensiblement identiques à celles exposées dans la figure 4 à l'exception du pas 15 séparant les diodes électroluminescentes 5 voisines qui est plus réduit, le pas 15 étant environ de 100 micromètres.

La figure 6 représente une autre alternative au premier mode de réalisation du dispositif lumineux 3, la couche absorbante 17 présentant un agencement similaire à celui observé dans la figure 4 par rapport aux différentes diodes électroluminescentes 5. Dans cette alternative, les diodes électroluminescentes 5 sont agencées sur le substrat 4 par groupe de trois diodes monochromatiques, chaque diode de ce groupe étant configurée pour émettre des rayons lumineux d'une couleur définie, notamment rouge vert et bleue. Les diodes électroluminescentes 5 monochromes présentent des dimensions inférieures à celles observées dans les figures 4 et 5. Conformément à ce qui précède, pour chacune de ces diodes électroluminescentes 5, la couche absorbante 17 comprend une cavité 23 aménagée de manière à découvrir la zone émettrice 9 de la diode électroluminescente 5 tandis que la couche absorbante 17 recouvre le corps 11 de la diode électroluminescente.

Par ailleurs, l'alternative représentée à la figure 6 diffère de ce qui précède en ce qu'une couche minérale intermédiaire 35 transparente est déposée sur la couche absorbante 17. Cette couche minérale intermédiaire 35 s'étend sur l'ensemble de la surface supérieure 31 de la couche absorbante 17 et également sur les pans inclinés 25 délimitant les différentes cavités 23, et recouvre les zones émettrices 9 des différentes diodes électroluminescentes 5 de le substrat 4. Avantageusement, la couche minérale intermédiaire 35 peut présenter un aspect rugueux. Une telle couche permet de renforcer la résistance chimique des différents composants, notamment face à l'humidité.

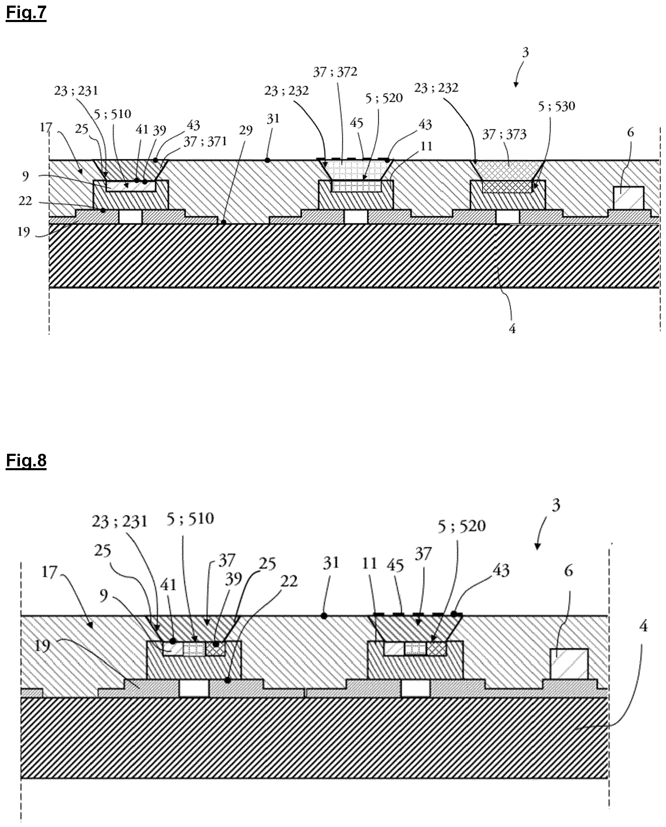

Les figures 7 à 10 représentent d'autres modes de réalisation dans lesquels le dispositif lumineux 3 comprend au moins une couche complémentaire 37, 38 protectrice, pouvant consister en une couche complémentaire locale 37 ou en une couche complémentaire de recouvrement 38, chacun de ces modes de réalisation pouvant être considéré avec les différentes alternatives précédemment exposées et représentées dans les figures 5 et 6. La couche complémentaire peut, selon qu'elle consiste en la couche complémentaire locale 37 ou en la couche complémentaire de recouvrement 38, être réalisée dans un matériau transparent, incolore ou teinté, ou dans un matériau luminophore, tel que davantage exposé ci-après.

Les figures 7 et 8 représentent un deuxième mode de réalisation de l'invention dans lequel une couche complémentaire est déposée de manière ciblée dans au moins l'une des cavités 23 de la couche absorbante 17 de manière à la remplir au moins partiellement et à former la couche complémentaire locale 37. La couche complémentaire locale 37 peut être réalisée par simple injection ou par surmoulage.

La couche complémentaire locale 37 peut être réalisée dans un matériau caractérisé par un premier indice de réfraction, sensiblement égal à un deuxième indice de réfraction de la zone émettrice 9 de la diode électroluminescente 5 disposée dans la cavité 23 correspondante.

Alternativement, cette couche complémentaire locale 37 peut être transparente incolore, être teintée ou être réalisée dans un matériau luminophore. Il résulte d'une telle alternative que la couche complémentaire locale 37 forme une protection mécanique des diodes électroluminescentes et peut dévier tout rayon lumineux externe résiduel qui pénètre dans la diode électroluminescente 5 au niveau de sa zone émettrice 9 de manière à réduire le risque de réflexion pouvant gêner un observateur extérieur, sans pour autant affecter les rayons lumineux émis par la diode électroluminescente 5 elle-même.

Par une couche complémentaire locale 37 « teintée », on entend que lorsque la cavité 23 est centrée sur la zone émettrice 9 d'une diode électroluminescente 5 monochrome, tel que cela est visible sur la figure 7, le matériau utilisé pour réaliser la couche complémentaire locale 37 au niveau de ladite cavité 23 peut être teinté dans une couleur sensiblement identique à la couleur des rayons émis par la diode électroluminescente 5.

Par exemple dans la figure 7, la portion du substrat 4 représenté comprend trois diodes électroluminescente 5 monochromes, chacune recouverte d'une couche complémentaire locale 37, chaque ensemble formé par une diode électroluminescente 5 et une couche complémentaire locale 37 étant destiné à produire respectivement des rayons lumineux rouges, verts et bleus.

Ainsi une première diode électroluminescente 510 peut, tel que représenté, être rouge, une première couche complémentaire locale 371, disposée dans une première cavité 231 centrée sur la zone émettrice 9 de la première diode électroluminescente 510, peut alors être teintée en rouge ou être transparent et incolore. Alternativement, la première diode électroluminescente 510 peut être monochrome et la première couche complémentaire locale 371 est réalisée dans un matériau luminophore destiné à modifier la longueur d'onde d'au moins une partie des photons émis par la première diode électroluminescente 510 afin de former du rouge.

De même, une deuxième diode électroluminescente 520 peut, tel qu'illustré, être verte et une deuxième couche complémentaire locale 372, disposée dans une deuxième cavité 232 qui est centrée sur la zone émettrice 9 de la deuxième diode électroluminescente 520 peut être teintée en vert. Alternativement, la deuxième diode électroluminescente 520 est monochrome, et la deuxième couche complémentaire locale 372 est réalisée dans un matériau luminophore destiné à former du vert.

Enfin, une troisième diode électroluminescente 530 peut, tel qu'illustré, être bleue et une troisième couche complémentaire locale 373, disposée dans une troisième cavité 233 qui est centrée sur la zone émettrice 9 de la deuxième diode électroluminescente 530 peut être teintée en bleu. Alternativement, la troisième diode électroluminescente 530 est monochrome, et la troisième couche complémentaire locale 373 est réalisée dans un matériau luminophore destiné à former du bleu.

Notamment, pour chaque diode électroluminescente 5 monochrome émettant une même couleur, l'ensemble des cavités 23 leur étant associées peuvent être remplies par un même matériau transparent, incolore ou teinté, ou un même matériau luminophore.

Il est à noter que l'alternative selon laquelle la couche complémentaire 37 est réalisée dans un matériau teinté ne peut être considérée que pour les diodes électroluminescentes 5 monochromes, telles que représentées dans la figure 7, et non pour les diodes électroluminescentes 5 de type RGB telles que représentées dans la figure 8.

Indépendamment du matériau considéré, la couche complémentaire locale 37 est configurée pour remplir au moins partiellement au moins l'une des cavités 23 de la couche absorbante 17 du dispositif lumineux 3. Une face inférieure 41 de la couche complémentaire locale 37 est en contact avec une face externe 39 de la zone émettrice 9 de la diode électroluminescente 5 ainsi qu'avec les pans inclinés 25 délimitant la cavité 23. Une face supérieure 43 de la couche complémentaire locale 37 peut être configurée de sorte que celle-ci présente un profil concave, convexe ou plan par rapport à la couche absorbante 17. Dans les exemples illustrés aux figures 7 et 8, les cavités 23 sont intégralement remplies par la couche complémentaire locale 37 et cette couche complémentaire locale 37 présente un profil plan. Additionnellement, la face supérieure 43 de la couche complémentaire locale 37 et la surface supérieure 31 de la couche absorbante 17 sont nivelées, c'est-à-dire disposées dans un même plan.

Avantageusement et comme exposé pour la surface supérieure 31 de la couche absorbante 17, la face supérieure 43 de la couche complémentaire 37 peut être plane et homogène, comme c'est le cas de la couche complémentaire 37 ménagée dans la première cavité 231 aux figures 7 et 8, ou la face supérieure 43 peut comprendre des éléments diffusants 45, tel que représenté pour la couche complémentaire 37 s'étendant dans la deuxième cavité 232. Ces éléments diffusants 45 peuvent consister en un grainage de la face supérieure 43, par exemple obtenu par traitement de surface par voie gazeuse, ou en des structures géométriques fines, pouvant être obtenues par moulage. Également, le dispositif lumineux 3 peut être configuré de sorte que la surface supérieure 31 de la couche absorbante 17 présente un grainage tandis que la face supérieure 43 de la couche complémentaire comprend les éléments diffusants 45.

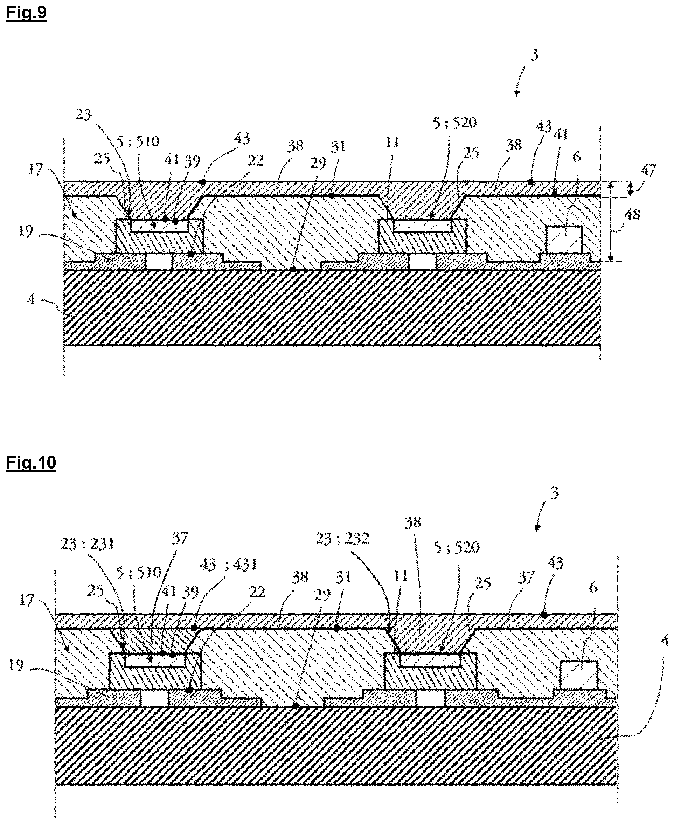

Les figures 9 et 10 illustrent un troisième et un quatrième mode de réalisation de la présente invention qui diffère de ce qui vient d'être décrit du deuxième mode de réalisation en ce que la couche complémentaire protectrice consiste ici au moins en une couche complémentaire de recouvrement 38 qui est disposée sur une surface plus étendue que la surface ciblée de la couche complémentaire précédemment décrite.

Dans le troisième mode de réalisation illustré sur la figure 9, une couche complémentaire de recouvrement 38 est déposée de manière à s'étendre dans au moins l'une des cavités 23 et en recouvrement de la surface supérieure 31 de la couche absorbante 17, la couche complémentaire de recouvrement 38 s'étendant d'un seul tenant sur la couche absorbante 17. Dans ce mode de réalisation, la couche complémentaire de recouvrement 38 est caractérisée par une épaisseur 47 comprise entre 1 et 40 micromètres, cette épaisseur 47 étant mesurée entre la face supérieure 43 et la face inférieure 41, selon une direction perpendiculaire à la couche absorbante 17 et dans une portion sensiblement plane de ladite couche absorbante 17 comprise entre deux diodes électroluminescentes 5. Similairement, l'ensemble formé par la couche absorbante 17 et la couche complémentaire de recouvrement 38 présente une épaisseur globale 48 inférieure à 200 micromètres.

Conformément à ce qui a été décrit pour le deuxième mode de réalisation, le dépôt de la couche complémentaire, ici la couche complémentaire de recouvrement 38 peut, par exemple, être réalisé par surmoulage ou par simple injection, le matériau déposé étant transparent et préférentiellement incolore.

La couche complémentaire de recouvrement 38 selon le troisième mode de réalisation peut ainsi être déposée sur l'ensemble de le substrat 4, de manière à remplir intégralement l'ensemble des cavités 23 de la couche absorbante 17, tel qu'illustré dans la figure 9, la face supérieure 43 de la couche complémentaire de recouvrement 38 étant plane et pouvant être lisse ou, tel que précédemment exposé, comprendre des éléments diffusants tels qu'un grainage ou des structures géométriques fines localisés en regard des cavités 23 centrées sur les zones émettrices 9 des diodes électroluminescentes 5.

Une combinaison du deuxième mode de réalisation et du troisième mode de réalisation peut être réalisée dans un quatrième mode de réalisation, tel qu'illustré sur la figure 10. Au moins l'une des cavités 23 peut, par exemple être au moins en partie remplie par une couche complémentaire locale 37 réalisée dans un matériau transparent, teinté ou luminophore, tandis qu'au moins une cavité 23 est remplie par la couche complémentaire de recouvrement 38 telle qu'elle vient d'être décrite, réalisée dans un matériau transparent et qui s'étend sur la surface supérieure 31 de la couche absorbante 17.

Dans l'exemple illustré, la première cavité 231 est remplie par la couche complémentaire locale 37, par exemple faite d'un matériau luminophore, le dépôt de la couche complémentaire locale 37 étant effectué de manière ciblée. La deuxième cavité 232 est remplie par la couche complémentaire de recouvrement 38, qui s'étend d'un seul tenant sur la surface supérieure 31 de la couche absorbante 17. La couche complémentaire de recouvrement 38 s'étend ainsi également de manière à recouvrir une première face supérieure 431 de la couche complémentaire locale 37.

Comme précédemment exposé, la face supérieure 43 de la couche complémentaire de recouvrement 38 peut être plane et homogène, ou comprendre des éléments diffusants tels qu'un grainage ou des structures géométriques fines, pouvant être obtenues par moulage.

Selon une configuration alternative non représentée, les différents modes de réalisation tels qu'exposés aux figures 7 à 10 peuvent également être mis en oeuvre dans un dispositif lumineux 3 comprenant la couche absorbante 17, une couche minérale intermédiaire transparente, déposée sur ladite couche absorbante 17, tel qu'illustrée dans la figure 6, et au moins une couche complémentaire, que ce soit une couche complémentaire locale 37 ou une couche complémentaire de recouvrement 38. La couche minérale intermédiaire 35 est alors, au moins en partie, comprise entre la couche absorbante 17 et la couche complémentaire locale 37 ou la couche complémentaire de recouvrement 38.

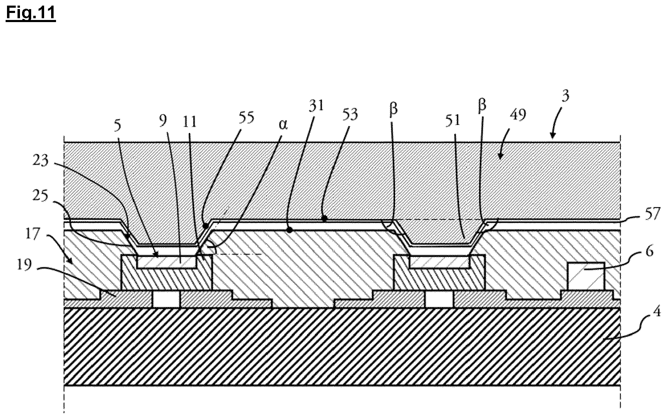

La figure 11 représente une étape de la réalisation du dispositif lumineux 3. Plus particulièrement, la figure 11 illustre le dépôt et la mise en forme, par surmoulage, de la couche absorbante 17 sur le substrat 4 porteur des diodes électroluminescentes 5 et des organes d'activation et/ou de contrôle 6. Le matériau opaque est injecté entre le substrat 4 et un contre-moule 49 configuré pour permettre la réalisation d'une pluralité de cavités 23 dans la couche absorbante 17. A cette fin une pluralité de reliefs 51 émerge d'un flanc inférieur 53 du contre-moule 49, c'est-à-dire le flanc en regard des sources lumineuses. La forme des reliefs 51 définit la forme des cavités 23 dans la couche absorbante 17 et les reliefs 51 sont configurés pour être ménagés en regard des zones émettrices 9 des diodes électroluminescentes 5 de le substrat 4 de support.

Lorsque le contre moule est abaissé, les reliefs 51 sont en contact avec les zones émettrices 9 des diodes électroluminescentes 5 et le matériau opaque injecté s'écoule autour des reliefs 51 sans pouvoir se répandre sur les zones émettrices 9. De la sorte, au terme de l'opération de surmoulage, toutes les parties visibles du substrat 4, à l'exception des zones émettrices 9 de chaque diode électroluminescente 5, sont recouvertes par la couche absorbante 17.

Notamment, les reliefs 51 sont caractérisés par un angle β, mesuré entre le flanc inférieur 53 et un flanc incliné 55 du relief 51 correspondant, l'angle β étant compris entre 135 et 180° et l'angle β définissant la valeur de l'angle α de la cavité 23. Le contre-moule 49 peut être recouvert d'un film d'interface 57 afin, d'une part, de protéger l'empreinte et le contre-moule 49 lors de l'injection du matériau opaque, par exemple de la résine, et d'autre part de faciliter l'étape de démoulage. Une telle technique est couramment appelée Film Assisted Molding (FAM).

Avantageusement, le contre-moule 49 peut être configuré pour réaliser une surface supérieure 31 homogène et lisse de la couche absorbante 17, ou à l'inverse pour que la couche absorbante 17 présente une surface supérieure 31 grainée lui conférant un aspect mat.

Une opération similaire pourra également être reproduite pour le dépôt des couches complémentaires de recouvrement ou des couches complémentaires locales, un contre-moule différent pouvant alors être utilisé.

On comprend à la lecture de ce qui précède que la présente invention propose un dispositif lumineux destiné à des systèmes de signalisation ou d'affichage d'informations, le dispositif lumineux comprenant un substrat porteur d'une pluralité de diodes électroluminescentes couverte au moins d'une couche absorbante particulièrement configurée pour assurer le recouvrement des différents composants du dispositif lumineux susceptibles de réfléchir des rayons lumineux externes au véhicule, à l'exception des zones émettrices de rayons lumineux des diodes électroluminescentes. De la sorte, la réflectivité du dispositif lumineux est limitée, tout comme la perte de contraste du signal lumineux qu'il émet. Également, la couche absorbante, ainsi que toute couche complémentaire additionnelle, telle qu'une couche complémentaire de recouvrement ou une couche complémentaire locale, confèrent une protection mécanique additionnelle aux différents composants du dispositif lumineux face aux conditions environnementales extérieures.

L'invention ne saurait toutefois se limiter aux moyens et configurations décrits et illustrés ici, et elle s'étend également à tout moyen ou configuration équivalents et à toute combinaison technique opérant de tels moyens. En particulier, le nombre, les dimensions, la forme et l'agencement des cavités pourront être modifiés sans nuire à l'invention, dans la mesure où le dispositif lumineux, in fine, remplit les mêmes fonctionnalités que celles décrites dans ce document.

## Revendications

1. Dispositif lumineux (3) pour véhicule (1) automobile comportant un substrat (4) de support et une pluralité de diodes électroluminescentes (5) disposées sur ce substrat (4) de support et comprenant chacune un corps (11) et une zone émettrice (9) de rayons lumineux, le dispositif lumineux (3) comportant également une glace de protection (7) disposée sur le trajet des rayons lumineux émis par les diodes électroluminescentes, **caractérisé en ce que** le dispositif lumineux (3) comprend au moins une couche absorbante (17) configurée pour recouvrir le substrat (4) et, au moins en partie, le corps (11) des diodes électroluminescentes (5) et **en ce que** la couche absorbante (17) présente une pluralité de cavités (23) chacune agencée en regard de la zone émettrice (9) de l'une des diodes électroluminescentes (5), les cavités (23) étant dimensionnées pour découvrir la zone émettrice (9) de chaque diode électroluminescente (5) tout en recouvrant le corps (11) entourant chacune de ces zones émettrices, chaque cavité (23) étant centrée sur une zone émettrice (9) de l'une des diodes électroluminescentes (5), et chaque cavité (23) étant délimitée par des pans inclinés (25) orientés pour que l'ouverture s'évase en s'éloignant de la diode et dont l'extrémité proximale, c'est à dire l'extrémité proche de la diode correspondante, longent les bords (27) de la zone émettrice (9) de la diode électroluminescente, de sorte que la couche absorbante (17) s'étend sur le corps (11) de la diode électroluminescente (5) sans entraver le passage des rayon lumineux émis par la zone émettrice (9).

2. Dispositif lumineux (3) selon la revendication précédente, dans lequel au moins l'une des cavités (23) est délimitée par une pluralité de pans inclinés (25), lesdits pans inclinés (25) présentant un angle α compris entre 0 et 45° par rapport à un plan d'extension (900) comprenant la zone émettrice (9) de la diode électroluminescente (5) correspondante.

3. Dispositif lumineux (3) selon l'une quelconque des revendications précédentes, dans lequel une surface supérieure (31) de la couche absorbante (17) comprend un grainage (33).

4. Dispositif lumineux (3) selon l'une quelconque des revendications précédentes, comprenant au moins une couche complémentaire (37, 38) qui s'étend au moins en partie dans au moins l'une des cavités (23) de la couche absorbante (17).

5. Dispositif lumineux (3) selon la revendication 4, dans lequel la couche complémentaire (37, 38) est transparente.

6. Dispositif lumineux (3) selon la revendication 4 ou 5, dans lequel la couche complémentaire (37, 38) consiste en une couche complémentaire locale (37) disposée dans l'une des cavités (23) et réalisée dans un matériau **caractérisé par** un premier indice de réfraction, sensiblement égal à un deuxième indice de réfraction de la zone émettrice (9) de la diode électroluminescente (5) disposée dans la cavité (23) correspondante.

7. Dispositif lumineux (3) selon la revendication 4, dans lequel la couche complémentaire (37, 38) consiste en une couche complémentaire locale (37) disposée dans l'une des cavités (23) et réalisée dans un matériau luminophore ou dans un matériau teinté dans une couleur sensiblement identique à une couleur de la lumière émise par la source de la diode électroluminescente (5) ménagée dans la cavité (23) correspondante.

8. Dispositif lumineux (3) selon la revendication 4 ou 5, dans lequel la couche complémentaire (37, 38) s'étend au moins en partie sur la couche absorbante (17).

9. Dispositif lumineux (3) selon l'une quelconque des revendications 4 à 8, dans lequel une face supérieure (43) de la couche complémentaire (37, 38), opposée à une face inférieure (41) de la couche complémentaire (37, 38) qui est en contact avec la zone émettrice (9) d'au moins l'une des diodes électroluminescente et/ou en contact avec la surface supérieure (31) de la couche absorbante (17), comprend des éléments diffusants (45).

10. Procédé de réalisation d'un dispositif lumineux (3) selon l'une des revendications précédentes, comprenant au moins une étape de surmoulage d'une couche absorbante (17) sur un substrat (4) de support porteur d'une pluralité de diodes électroluminescentes (5) au cours de laquelle on injecte un premier matériau, absorbant et/ou opaque, entre ledit substrat (4) et un contre-moule (49) comprenant une pluralité de reliefs (51) configurés pour recouvrir respectivement une zone émettrice (9) d'une diode électroluminescente (5).

## Patentansprüche

1. Leuchtvorrichtung (3) für ein Kraftfahrzeug (1), beinhaltend ein Trägersubstrat (4) und eine Mehrzahl von Leuchtdioden (5), die auf diesem Trägersubstrat (4) angeordnet sind und jeweils einen Körper (11) und einen Lichtstrahlen emittierenden Bereich (9) umfassen, wobei die Leuchtvorrichtung (3) auch eine Schutzscheibe (7) beinhaltet, die auf dem Weg der von den Leuchtdioden emittierten Lichtstrahlen angeordnet ist, **dadurch gekennzeichnet, dass** die Leuchtvorrichtung (3) mindestens eine absorbierende Schicht (17) umfasst, die dazu ausgestaltet ist, das Substrat (4) und, mindestens zum Teil, den Körper (11) der Leuchtdioden (5) zu bedecken, und dadurch, dass die absorbierende Schicht (17) eine Mehrzahl von Kavitäten (23) aufweist, von denen jede gegenüber dem emittierenden Bereich (9) einer der Leuchtdioden (5) angeordnet ist, wobei die Kavitäten (23) so dimensioniert sind, dass der emittierende Bereich (9) jeder Leuchtdiode (5) freigelegt wird und gleichzeitig der Körper (11), der jeden dieser emittierenden Bereiche umgibt, bedeckt wird, wobei jede Kavität (23) auf einen emittierenden Bereich (9) einer der Leuchtdioden (5) zentriert ist und wobei jede Kavität (23) durch geneigte Flächen (25) begrenzt wird, die so ausgerichtet sind, dass die Öffnung mit zunehmender Entfernung von der Diode weiter wird, und deren proximales Ende, d. h. das der entsprechenden Diode nahe Ende, an den Rändern (27) des emittierenden Bereichs (9) der Leuchtdiode entlangläuft, so dass sich die absorbierende Schicht (17) auf dem Körper (11) der Leuchtdiode (5) erstreckt, ohne den Durchgang der von dem emittierenden Bereich (9) emittierten Lichtstrahlen zu behindern.

2. Leuchtvorrichtung (3) nach dem vorhergehenden Anspruch, bei der mindestens eine der Kavitäten (23) durch eine Mehrzahl von geneigten Flächen (25) begrenzt wird, wobei die geneigten Flächen (25) einen Winkel α zwischen 0 und 45° in Bezug auf eine Erstreckungsebene (900) aufweisen, die den emittierenden Bereich (9) der entsprechenden Leuchtdiode (5) umfasst.

3. Leuchtvorrichtung (3) nach einem der vorhergehenden Ansprüche, bei der eine obere Oberfläche (31) der absorbierenden Schicht (17) eine Körnung (33) umfasst.

4. Leuchtvorrichtung (3) nach einem der vorhergehenden Ansprüche, umfassend mindestens eine ergänzende Schicht (37, 38), die sich mindestens zum Teil in mindestens einer der Kavitäten (23) der absorbierenden Schicht (17) erstreckt.

5. Leuchtvorrichtung (3) nach Anspruch 4, bei der die ergänzende Schicht (37, 38) transparent ist.

6. Leuchtvorrichtung (3) nach Anspruch 4 oder 5, bei der die ergänzende Schicht (37, 38) aus einer lokalen ergänzenden Schicht (37) besteht, die in einer der Kavitäten (23) angeordnet ist und aus einem Material ausgeführt ist, das durch einen ersten Brechungsindex gekennzeichnet ist, der im Wesentlichen gleich einem zweiten Brechungsindex des emittierenden Bereichs (9) der Leuchtdiode (5) ist, die in der entsprechenden Kavität (23) angeordnet ist.

7. Leuchtvorrichtung (3) nach Anspruch 4, bei der die ergänzende Schicht (37, 38) aus einer lokalen ergänzenden Schicht (37) besteht, die in einer der Kavitäten (23) angeordnet ist und aus einem Luminophor-Material ausgeführt ist oder aus einem Material, das in einer Farbe eingefärbt ist, die im Wesentlichen identisch mit einer Farbe des Lichts ist, das von der Quelle der Leuchtdiode (5) emittiert wird, die in der entsprechenden Kavität (23) ausgebildet ist.

8. Leuchtvorrichtung (3) nach Anspruch 4 oder 5, bei der sich die ergänzende Schicht (37, 38) mindestens zum Teil auf der absorbierenden Schicht (17) erstreckt.

9. Leuchtvorrichtung (3) nach einem der Ansprüche 4 bis 8, bei der eine Oberseite (43) der ergänzenden Schicht (37, 38), die entgegengesetzt zu einer Unterseite (41) der ergänzenden Schicht (37, 38) ist, die mit dem emittierenden Bereich (9) mindestens einer der Leuchtdioden in Kontakt ist und/oder mit der oberen Oberfläche (31) der absorbierenden Schicht (17) in Kontakt ist, streuende Elemente (45) umfasst.

10. Verfahren zur Herstellung einer Leuchtvorrichtung (3) nach einem der vorhergehenden Ansprüche, umfassend mindestens einen Schritt des Anformens einer absorbierenden Schicht (17) an ein Trägersubstrat (4), das eine Mehrzahl von Leuchtdioden (5) trägt, in dessen Verlauf ein erstes, absorbierendes und/oder undurchsichtiges, Material zwischen das Substrat (4) und eine Gegenform (49) gespritzt wird, die eine Mehrzahl von Erhebungen (51) umfasst, die dazu ausgestaltet sind, jeweils einen emittierenden Bereich (9) einer Leuchtdiode (5) zu bedecken.

## Claims

1. Luminous device (3) for a motor vehicle (1), said device comprising a carrier substrate (4) and a plurality of light-emitting diodes (5) placed on this carrier substrate (4) and each comprising a body (11) and a light-ray-emitting region (9), the luminous device (3) also comprising a protective outer lens (7) placed on the path of the light rays emitted by the light-emitting diodes, **characterized in that** the luminous device (3) comprises at least one absorbent layer (17) configured to cover the substrate (4) and, at least in part, the body (11) of the light-emitting diodes (5) and **in that** the absorbent layer (17) comprises a plurality of cavities (23) each arranged facing the emitting region (9) of one of the light-emitting diodes (5), the cavities (23) being dimensioned to leave uncovered the emitting region (9) of each light-emitting diode (5) while covering the body (11) encircling each of these emitting regions, each cavity (23) being centred on an emitting region (9) of one of the light-emitting diodes (5), and each cavity (23) being bounded by inclined sides (25), which are oriented so that the opening flares and gets larger with distance from the diode, and the near ends of which, i.e. the ends next to the corresponding diode, extend along the edges (27) of the emitting region (9) of the light-emitting diode, and hence the absorbent layer (17) extends over the body (11) of the light-emitting diode (5) without impeding the passage of the light rays emitted by the emitting region (9).

2. Luminous device (3) according to the preceding claim, wherein at least one of the cavities (23) is bounded by a plurality of inclined sides (25), said inclined sides (25) making an angle α comprised between 0 and 45° to an extension plane (900) comprising the emitting region (9) of the corresponding light-emitting diode (5).

3. Luminous device (3) according to any one of the preceding claims, wherein an upper surface (31) of the absorbent layer (17) comprises a graining (33).

4. Luminous device (3) according to any one of the preceding claims, comprising at least one complementary layer (37, 38) that extends at least in part into at least one of the cavities (23) of the absorbent layer (17) .

5. Luminous device (3) according to Claim 4, wherein the complementary layer (37, 38) is transparent.

6. Luminous device (3) according to Claim 4 or 5, wherein the complementary layer (37, 38) consists of a local complementary layer (37) placed in one of the cavities (23) and made of a material **characterized by** a first refractive index that is substantially equal to a second refractive index of the emitting region (9) of the light-emitting diode (5) placed in the corresponding cavity (23).

7. Luminous device (3) according to Claim 4, wherein the complementary layer (37, 38) consists of a local complementary layer (37) placed in one of the cavities (23) and made of a phosphor or of a material tinted to have a colour substantially identical to a colour of the light emitted by the source of the light-emitting diode (5) housed in the corresponding cavity (23).

8. Luminous device (3) according to Claim 4 or 5, wherein the complementary layer (37, 38) extends at least in part over the absorbent layer (17).

9. Luminous device (3) according to any one of Claims 4 to 8, wherein an upper face (43) of the complementary layer (37, 38), opposite a lower face (41) of the complementary layer (37, 38) that makes contact with the emitting region (9) of at least one of the light-emitting diodes and/or makes contact with the upper surface (31) of the absorbent layer (17), comprises scattering elements (45) .

10. Process for producing a luminous device (3) according to one of the preceding claims, comprising at least one step of overmoulding an absorbent layer (17) on a carrier substrate (4) bearing a plurality of light-emitting diodes (5), in which step an, absorbent and/or opaque, first material is injected between said substrate (4) and a counter-mould (49) comprising a plurality of reliefs (51) that are configured to respectively cover an emitting region (9) of one light-emitting diode (5).
